# EUROPÄISCHE PATENTSCHRIFT

(11) **EP 0 969 475 B1**
(45) Veröffentlichungstag und Bekanntmachung des Hinweises auf die Patenterteilung: **16.08.2006**
(21) Anmeldenummer: 99113048.5
(22) Anmeldetag: 30.06.1999
(51) Int. Cl.: G11C 7/00

(54) **Dynamische Halbleiter-Speichervorrichtung und Verfahren zur Initialisierung einer dynamischen Halbleiter-Speichervorrichtung**
Dynamic semiconductor memory and method for the initialisation of a dynamic semiconductor memory
Mémoire dynamique à semi-conducteur et méthode pour l'initialisation d'une mémoire dynamique à semi-conducteur

(30) Priorität: 30.06.1998 DE 19829287
(43) Veröffentlichungstag der Anmeldung: 05.01.2000
(73) Patentinhaber: Infineon Technologies AG, 81669 München (DE)
(72) Erfinder: Krause, Gunnar, 81451 München (DE)
(74) Vertreter: Epping - Hermann - Fischer

(56) Entgegenhaltungen:
- EP-A- 0 797 207
- JP-A- 9 106 668

## Beschreibung

Die Erfindung betrifft eine dynamische Halbleiter-Speichervorrichtung vom wahlweisen Zugriffstyp (DRAM/SDRAM) mit einer den Einschaltvorgang der Halbleiter-Speichervorrichtung und ihrer Schaltungsbestandteile steuernden Initialisierungsschaltung, welche nach einer nach dem Einschalten der Halbleiter-Speichervorrichtung erfolgten Stabilisierung der Versorgungsspannung ein Versorgungssspannungsstabilsignal (POWERON) liefert, wobei die Initialisierungsschaltung eine dem Versorgungsspannungsstabilsignal und weiteren, von außen an die Halbleiter-Speichervorrichtung angelegten Kommandosignalen (PRE, ARF, MRS) zugeordnete Freigabeschaltung aufweist, welche nach dem Erkennen einer vorbestimmten ordnungsgemäßen Initialisierungsabfolge der an die Halbleiter-Speichervorrichtung angelegten Kommandosignale Kommandosignalen (PRE, ARF, MRS) ein Freigabesignal (CHIPREADY) liefert, welches die Entriegelung einer zum ordnungsgemäßen Betrieb der Halbleiter-Speichervorrichtung vorgesehenen Steuerschaltung bewirkt. Solch eine Halbleiter-Speichervorrichtung ist aus JP 09 106668 A bekannt. Die Erfindung betrifft ferner ein Verfahren zur Initialisierung einer solchen dynamischen Halbleiter-Speichervorrichtung gemäß Anspruch 10.

Bei SDRAM-Halbleiterspeichern nach dem JEDEC-Standard ist während des Einschaltvorganges ("POWERUP") dafür zu sorgen, dass die internen, für den ordnungsgemäßen Betrieb der Halbleiter-Speichervorrichtung vorgesehenen Steuerschaltungen sicher in einem definierten Sollzustand gehalten werden, um eine unerwünschte Aktivierung von Ausgangstransistoren zu verhindern, die auf den Datenleitungen einen Kurzschluss (sogenannte "Bus Contention" bzw. "Data Contention") oder eine unkontrollierte Aktivierung von internen Stromverbrauchern hervorrufen würde. Aufgrund einer prinzipiellen Unvorhersehbarkeit des zeitlichen Verlaufes der Versorgungsspannung und des bzw. der Spannungspegel an den externen Steuereingängen während des Einschaltvorganges des Halbleiter-Speichers gestaltet sich die Lösung dieses Problems schwierig. Nach den Herstellerspezifikationen sollte ein SDRAM-Bauelement sämtliche Befehle, die zeitlich vor einer definierten Initialisierungsabfolge anliegen, ignorieren. Diese Abfolge besteht aus vorbestimmten Kommandos, die in einer definierten zeitlichen Reihenfolge angelegt werden müssen. Eine Reihe von Funktionen und Kommandos, die im ordnungsgemäßen Betrieb des Bauelementes erlaubt sind, sind jedoch zeitlich erst nach der Initialisierungsabfolge erwünscht bzw. erlaubt. Nach dem JEDEC-Standard für SDRAM-Halbleiter-Speicher ist eine empfohlene Initialisierungsabfolge (sogenannte "POWERON-SEQUENCE") wie folgt vorgesehen:
1. Anlegen eines Versorgungsspannungs- und Startimpulses, um die Aufrechterhaltung einer NOP-Bedingung bei den Eingängen des Bauelementes zu erzielen.
2. Aufrechterhaltung einer stabilen Versorgungsspannung, eines stabilen Taktes, und von stabilen NOP-Eingangsbedingungen für eine Mindestzeitdauer von 200 µs.
3. Vorbereitungskommando für die Wortleitungsaktivierung (PRECHARGE) für sämtliche Speicherbänke der Vorrichtung.
4. Aktivierung von acht oder mehreren Auffrischungskommandos (AUTOREFRESH).
5. Aktivierung des Lade-Konfigurations-Register-Kommandos (MODE-REGISTER-SET) zur Initialisierung des Modusregisters.

Nach dem Erkennen einer solchen definierten Initialisierungsabfolge befindet sich der Speicherbaustein normalerweise in einem sogenannten IDLE-Zustand, d.h. er ist vorgeladen und für den ordnungsgemäßen Betrieb vorbereitet. Bei den bisher bekannt gewordenen SDRAM-Halbleiter-Speicherbausteinen wurden sämtliche Steuerschaltungen des Bauelementes lediglich mit dem POWERON-Signal entriegelt. Dieses Signal POWERON ist aktiv, wenn die internen Versorgungsspannungen die erforderlichen Werte erreicht haben, die zum ordnungsgemäßen Betrieb des Bauelementes erforderlich sind. Danach ist der Baustein in der Lage, Befehle anzuerkennen und auszuführen.

Der Erfindung liegt die Aufgabe zugrunde, eine konstruktiv möglichst einfache Verbesserung der Steuerung des Einschaltvorganges bei dynamischen Halbleiter-Speichervorrichtungen vom wahlweisen Zugriffstyp (DRAM oder SDRAM) anzugeben, mit welcher die Gefahr eines Kurzschlusses der Datenleitungen und/oder einer unkontrollierten Aktivierung von internen Stromverbrauchern wirksam verhindert wird.

Diese Aufgabe wird durch eine dynamische Halbleiter-Speichervorrichtung vom wahlweisen Zugriffstyp nach Anspruch 1 und ein Verfahren zur Initialisierung einer solchen Halbleiter-Speichervorrichtung nach Anspruch 10 gelöst.

Erfindungsgemäß ist vorgesehen, dass die Initialisierungsschaltung eine dem Versorgungssspannungsstabilsignal und weiteren, von außen an die Halbleiter-Speichervorrichtung angelegten Kommandosignalen zugeordnete Freigabeschaltung aufweist, welche nach dem Erkennen einer vorbestimmten ordnungsgemäßen Initialisierungsabfolge der an die Halbleiter-Speichervorrichtung angelegten Kommandosignale ein Freigabesignal liefert, welches die Entriegelung der zum ordnungsgemäßen Betrieb der Halbleiter-Speichervorrichtung vorgesehenen Steuerschaltung bewirkt.

Dem Prinzip der Erfindung folgend wird ein Freigabesignal (CHIPREADY) generiert, welches in Abhängigkeit weiterer interner Signale und der Initialisierungsabfolge aktiv wird und danach vorbestimmte Schaltungen entriegelt. Bis zur Beendigung der vorgegebenen Initialisierungsabfolge bleiben die vorbestimmten Schaltungen verriegelt. Beispielsweise werden Kommandos decodiert, jedoch nicht ausgeführt, und die Ausgangstreiber hochohmig gehalten.

Erfindungsgemäß ist vorgesehen, dass die von außen an die Halbleiter-Speichervorrichtung angelegten Kommandosignale der von der Freigabeschaltung erkennenden Initialisierungsabfolge das Vorbereitungskommando für die Wortleitungsaktivierung (PRECHARGE), und/oder das Auffrischungskommando (AUTOREFRESH), und/oder das Lade-Konfigurations-Register-Kommando (MODE-REGISTER-SET) aufweist.

Nach einer vorteilhaften konstruktiven Ausgestaltung der erfindungsgemäßen Initialisierungsschaltung ist vorgesehen, dass die Freigabeschaltung wenigstens eine bistabile Kippschaltungsstufe mit einem Setzeingang, an dem ein Kommandosignal (PRECHARGE, AUTOREFRESH, MODE-REGISTER-SET) anliegt, einem Rücksetzeingang, an dem das Versorgungsspannungsstabilsignal (POWERON) oder ein davon abgeleitetes bzw. verknüpftes Signal anliegt, und mit einem Ausgang, an dem das Freigabesignal (CHIPREADY) abgeleitet ist, aufweist.

Insbesondere besitzt die Freigabeschaltung mehrere, jeweils einem Kommandosignal zugeordnete bistabile Kippschaltungsstufen.

In zweckmäßiger Ausgestaltung der Erfindung ist vorgesehen, dass der Ausgang wenigstens einer der bistabilen Kippschaltungsstufen an einen Rücksetzeingang einer weiteren Kippschaltungsstufe geführt ist. Hierbei kann des Weiteren vorgesehen sein, dass bei einer der bistabilen Kippschaltungsstufe das Versorgungssspannungsstabilsignal (POWERON) und das von dem Ausgang einer weiteren Kippschaltungsstufe ausgegebene Signal über ein Gatter logisch verknüpft an den Rücksetzeingang der Kippschaltungsstufe geführt sind.

Weitere vorteilhafte Ausgestaltungen der Erfindung ergeben sich aus den Unteransprüchen.

Nachfolgend wird die Erfindung anhand mehrerer in der Zeichnung dargestellter Ausführungsbeispiele weiter erläutert. Es zeigt:
- Figur 1: eine schematische Blockdarstellung einer den Einschaltvorgang des Halbleiterspeichers und ihrer Schaltungsbestandteile steuernden Initialisierungsschaltung;
- Figur 2: ein schematisches Schaltbild einer das Freigabesignal (CHIPREADY) liefernden Freigabeschaltung;
- Figur 3: ein Zeitablaufdiagramm zur Erläuterung der Funktionsweise der Schaltung nach Figur 2;
- Figur 4: ein Schaltbild einer Freigabeschaltung nach einem Ausführungsbeispiel der Erfindung.

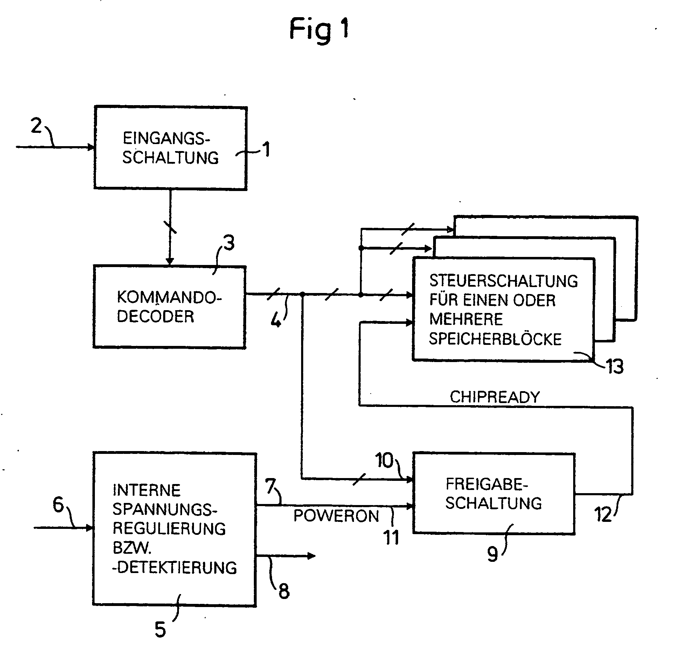

Figur 1 zeigt die für das Verständnis der Erfindung wichtigen Schaltungsbestandteile einer nach dem JEDEC-Standard arbeitenden SDRAM-Speichervorrichtung mit einer den Einschaltvorgang der Halbleiterspeichervorrichtung und ihrer Schaltungsbestandteile steuernden Initialisierungsschaltung mit einer Eingangsschaltung 1, an deren Eingang 2 die von außen an den Halbleiterspeicher einzugebenden Kommando- und Taktsignale anliegen, verstärkt und aufbereitet werden, einem der Eingangsschaltung 1 nachgeschalteten Kommandodecoder 3, an dessen Ausgang 4 unter anderem die Kommandosignale PRE bzw. PRECHARGE (Vorbereitungskommando für die Wortleitungsaktivierung), ARF bzw. AUTOREFRESH (Auffrischungskommando) und MRS bzw. MODE-REGISTER-SET (Lade-Konfiguration-Register-Kommando) ausgegeben werden, sowie einer Schaltung 5 für die interne Spannungsregulierung bzw. -detektierung, an deren Eingang 6 die von außen an den Halbleiter-Speicher anliegenden externen Versorgungsspannungen zugeführt sind, und an deren Ausgang 7 das POWERON-Signal und an deren Ausgang 8 die stabilisierten internen Versorgungsspannungen geliefert werden. Die Funktionsweise und der Aufbau der Schaltungen 1, 3 und 5 ist dem Fachmann hinreichend bekannt und braucht daher nicht näher erläutert werden. Wichtig für das Verständnis der Erfindung ist, dass die Schaltung 5 ein aktives POWERON-Signal liefert, wenn nach der POWERUP-Phase des SDRAM-Speichers die am Ausgang 8 anliegenden internen Versorgungsspannungen die für den ordnungsgemäßen Betrieb des Bauelementes erforderlichen Werte erreicht haben.

Nach der Erfindung besitzt die Initialisierungsschaltung darüber hinaus eine den Schaltungen 3 und 5 nachgeschaltete Freigabeschaltung 9, an deren Eingang 10 unter anderem die Kommandosignale PRE, ARF und MRS, an deren Eingang 11 das POWERON-Signal anliegt, und an deren Ausgang 12 das nach dem Erkennen einer vorbestimmten ordnungsgemäßen Initialisierungsabfolge der an die Halbleiter-Speichervorrichtung angelegten Kommandosignale ein Freigabesignal CHIPREADY geliefert wird, welches die Entriegelung der zum ordnungsgemäßen Betrieb der Halbleiter-Speichervorrichtung vorgesehenen Steuerschaltungen 13 bewirkt. Diese internen Steuerschaltungen 13 dienen unter anderem der Ablaufsteuerung für einen oder mehrere der (nicht näher dargestellten) Speicherblöcke des SDRAM-Speichers und sind als solche bekannt.

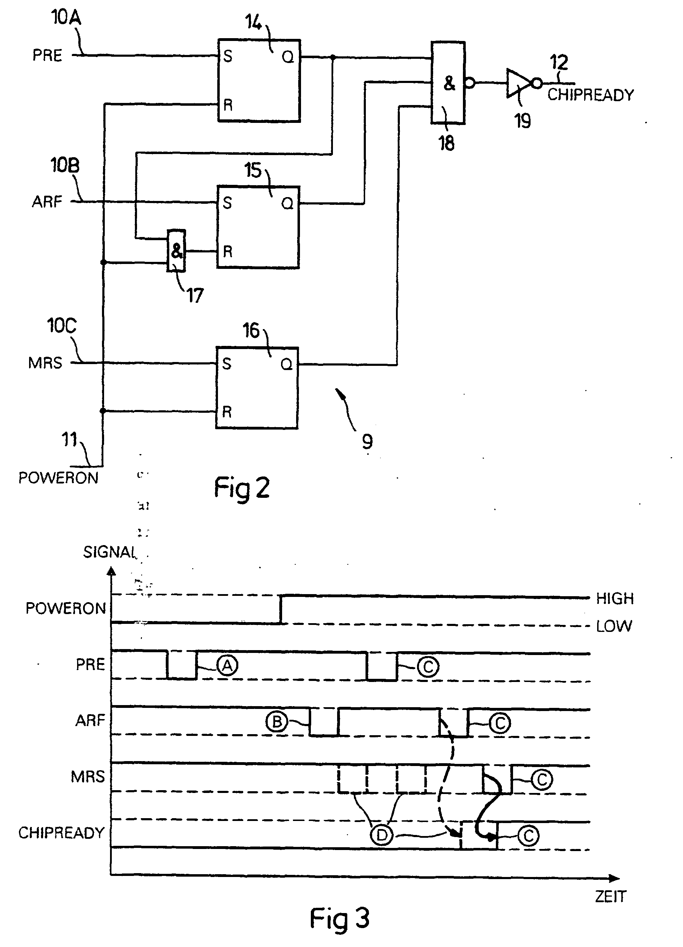

Figur 2 zeigt ein bevorzugtes Ausführungsbeispiel der Freigabeschaltung 9 nach der Erfindung. Diese umfasst drei bistabile Kippschaltungsstufen 14, 15 und 16 mit jeweils einem Setzeingang S, einem Rücksetzeingang R, sowie einem Ausgang Q, ein dem Rücksetzeingang R der Kippschaltungsstufe 15 vorgeschaltetes UND-Gatter 17, ein sämtlichen Ausgängen Q der Kippschaltungsstufen 14, 15, 16 nachgeschaltetes UND-Gatter 18, sowie einem dem UND-Gatter 18 nachgeschalteten Inverter 19, an dessen Ausgang 12 das Freigabesignal CHIPREADY ausgegeben wird, wobei das Freigabesignal HIGH-aktiv ist, d.h. aktiviert ist, wenn sein Spannungspegel auf logisch HIGH ist. Die an den jeweiligen Setzeingängen S der bistabilen Kippschaltungsstufen 14, 15, 16 anliegenden Kommandosignale PRE, ARF, MRS sind jeweils LOW-aktiv, d.h. diese Signale sind aktiv, wenn ihr Spannungspegel auf logisch LOW liegt, während das POWERON-Signal wiederum HIHG-aktiv ist. Das POWERON-Signal liegt bei den Kippschaltungsstufen 14 und 16 unmittelbar an den Rücksetzeingängen R an und liegt bei der Kippschaltungsstufe 15 zunächst an dem einen Eingang des UND-Gatters 17 an, an dessen anderem Eingang das von dem Ausgang Q der Kippschaltungsstufe 14 ausgegebenen Signal anliegt, wobei der Ausgang des UND-Gatters 17 mit dem Rücksetzeingang der Kippschaltungsstufe 15 verbunden ist.

Die Funktionsweise der in Figur 2 dargestellten Freigabeschaltung 9 ist dergestalt, dass eine Aktivierung des Freigabesignales CHIPREADY am Ausgang 12 auf logisch HIGH erst dann generiert wird, wenn eine vorbestimmte zeitliche Initialisierungsabfolge der Kommandosignale PRE, ARF und MRS und eine Aktivierung des POWERON-Signales auf den logischen Pegel HIGH detektiert wird. Erst danach werden aufgrund der Aktivierung des Freigabesignales CHIPREADY die Steuerschaltungen entriegelt; vorher bleiben diese Schaltungen verriegelt.

In dem schematischen Zeitablaufdiagramm nach Figur 3 sind beispielhafte Kommandoabfolgen während des Einschaltvorganges der Halbleiter-Speichervorrichtung zur Erläuterung der Funktionsweise der Freigabeschaltung 9 dargestellt.

Bei der Fallkonstellation A erfolgt eine gegenüber der Aktivierung des POWERON-Signales zu frühe Aktivierung des Signales PRECHARGE auf LOW-aktiv, so dass konsequenterweise noch keine Aktivierung des Freigabesignales CHIPREADY auf logisch LOW erfolgt, da die ordnungsgemäße Initialisierungsabfolge eine Wartezeit vor dem ersten Kommando erfordert. Richtigerweise wird damit der Signalhub des Kommandos PRECHARGE nach der Fallkonstellation A ignoriert. Bei der Fallkonstellation B ist die zeitliche Reihenfolge der Aktivierung des Signales AUTOFRESH auf logisch LOW falsch, da die ordnungsgemäße Initialisierungsabfolge einen vorherigen PRECHARGE-Befehl vor dem AUTOREFRESH-Befehl vorschreibt. Der Signalhub des AUTOREFRESH-Signales auf logisch LOW nach der Fallkonstellation B wird daher ebenfalls ignoriert, das Freigabesignal geht nicht auf logisch HIGH. Bei der Fallkonstellation C liegt - konform mit dem JEDEC-Standard - eine richtige zeitliche Reihenfolge der Befehle PRECHARGE, AUTOREFRESH, MODE-REGISTER-SET vor; folgerichtig wird nun, nachdem auch das POWERON-Signal auf logisch HIGH ist, ein Freigabesignal CHIPREADY auf logisch HIGH geliefert. Mit dem Symbol D ist strichliert dargestellt noch eine weitere denkbare, erlaubte und daher ein Freigabesignal auslösende Initialisierungsabfolge dargestellt: Eine Aktivierung des Kommandos MODE-REGISTER-SET auf logisch LOW ist nach der Aktivierung des POWERON-Signales jederzeit erlaubt.

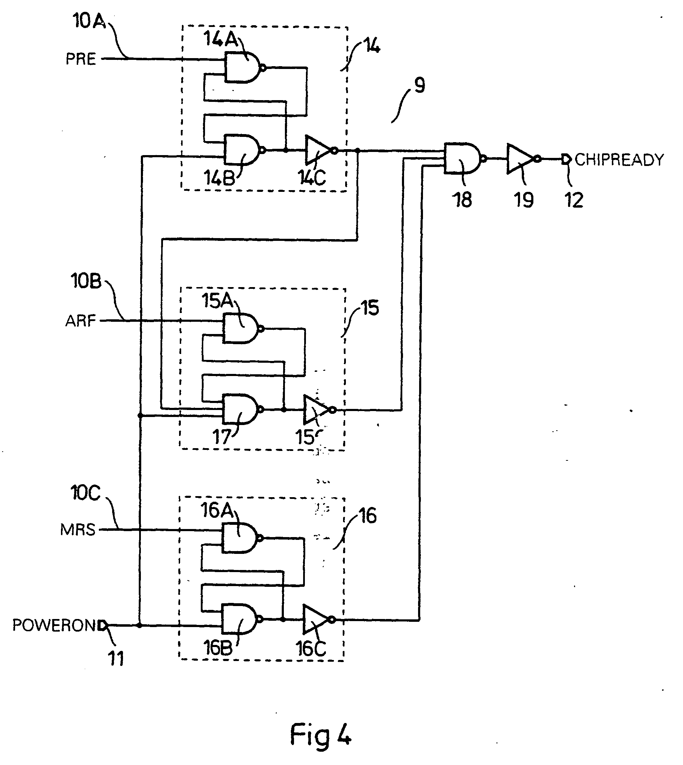

Figur 4 zeigt in näheren Einzelheiten ein bevorzugtes Ausführungsbeispiel einer erfindungsgemäßen Freigabeschaltung 9. Bei diesem Ausführungsbeispiel ist jede bistabile Kippstufe 14, 15, 16 aus jeweils zwei NAND-Gattern 14A, 14B, 15A, 17, 16A, 16B, sowie einem Inverter 14C, 15C und 16C aufgebaut, die in der dargestellten Art und Weise miteinander verbunden sind. Bei der bistabilen Kippstufe 15 ist das NAND-Gatter 17 mit drei Eingängen versehen.

## Patentansprüche

1. Dynamische Halbleiter-Speichervorrichtung vom wahlweisen Zugriffstyp (DRAM/SDRAM) mit einer den Einschaltvorgang der Halbleiter-Speichervorrichtung und ihrer Schaltungsbestandteile steuernden Initialisierungsschaltung, welche nach einer nach dem Einschalten der Halbleiter-Speichervorrichtung erfolgten Stabilisierung der Versorgungsspannung ein Versorgungsspannungsstabilsignal (POWERON) liefert,
wobei die Initialisierungsschaltung eine dem Versorgungsspannungsstabilsignal (POWERON) und weiteren, von außen an die Halbleiter-Speichervorrichtung angelegten Kommandosignalen (PRE, ARF, MRS) zugeordnete Freigabeschaltung (9) aufweist, welche nach dem Erkennen einer vorbestimmten ordnungsgemäßen Initialisierungsabfolge der an die Halbleiter-Speichervorrichtung angelegten Kommandosignale Kommandosignalen (PRE, ARF, MRS) ein Freigabesignal (CHIPREADY) liefert, welches die Entriegelung einer zum ordnungsgemäßen Betrieb der Halbleiter-Speichervorrichtung vorgesehenen Steuerschaltung (13) bewirkt,
**dadurch gekennzeichnet,**
**dass** die von außen an die Halbleiter-Speichervorrichtung angelegten Kommandosignale (PRE, ARF, MRS) der von der Freigabeschaltung (9) erkennenden Initialisierungsabfolge das Vorbereitungskommando für die Wortleitungsaktivierung (PRECHARGE), und/oder das Auffrischungskommando (AUTOREFRESH), und/oder das Lade-Konfigurations-Register-Kommando (MODE-REGISTER-SET) aufweist.

2. Halbleiter-Speichervorrichtung nach Anspruch 1,
**dadurch gekennzeichnet,**
**dass** die Freigabeschaltung (9) wenigstens eine bistabile Kippschaltungsstufe (14, 15, 16) mit einem Setzeingang (S), an dem ein Kommandosignal (PRECHARGE, AUTOREFRESH, MODE-REGISTER-SET) anliegt, einem Rücksetzeingang (R), an dem das Versorgungsspannungsstabilsignal (POWERON) oder ein davon abgeleitetes bzw. verknüpftes Signal anliegt, und mit einem Ausgang (Q), an dem das Freigabesignal (CHIPREADY) (9) abgeleitet ist, aufweist.

3. Halbleiter-Speichervorrichtung nach Anspruch 2,
**dadurch gekennzeichnet,**
**dass** die Freigabeschaltung (9) mehrere, jeweils einem Kommandosignal (PRE, ARF, MRS) zugeordnete bistabile Kippschaltungsstufen (14, 15, 16) aufweist.

4. Halbleiter-Speichervorrichtung nach Anspruch 2 oder 3,
**dadurch gekennzeichnet,**
**dass** der Ausgang (Q) wenigstens einer der bistabilen Kippschaltungsstufen (14) an einen Rücksetzeingang einer weiteren Kippschaltungsstufe (15) geführt ist.

5. Halbleiter-Speichervorrichtung nach Anspruch 3 oder 4,
**dadurch gekennzeichnet,**
**dass** bei einer der bistabilen Kippschaltungsstufen (15) das Versorgungsspannungsstabilsignal (POWERON) und das von dem Ausgang (Q) einer weiteren Kippschaltungsstufe (14) ausgegebene Signal über ein Gatter (17) logisch verknüpft an den Rücksetzeingang (R) der Kippschaltungsstufe (15) geführt sind.

6. Halbleiter-Speichervorrichtung nach einem der Ansprüche 3 bis 5,
**dadurch gekennzeichnet,**
**dass** die bistabile Kippschaltungsstufe (14, 15, 16) jeweils durch ein aus wenigstens zwei NOR- oder NAND-Gattern (14A, 14B, 15A, 17, 16A, 16B) aufgebautes RS-Flip-Flop ausgebildet ist.

7. Halbleiter-Speichervorrichtung nach einem der Ansprüche 1 bis 6,
**dadurch gekennzeichnet,**
**dass** die von der Freigabeschaltung (9) als ordnungsgemäße Initialisierungsabfolge erkannte und das Freigabesignal (CHIPREADY) auslösende Initialisierungsabfolge eine mit dem JEDEC-Standard konforme Kommandofolge darstellt.

8. Halbleiter-Speichervorrichtung nach einem der Ansprüche 1 bis 7,
**dadurch gekennzeichnet,**
**dass** die Ausgangstreiber der Halbleiter-Speichervorrichtung beim Einschaltvorgang bis zur Ausgabe des von der Freigabeschaltung (9) gelieferten Freigabesignals (CHIPREADY) verriegelt bleiben.

9. Halbleiter-Speichervorrichtung nach einem der Ansprüche 1 bis 8,
**dadurch gekennzeichnet,**
**dass** eine ordnungsgemäße Initialisierungsabfolge, welche die Auslösung eines Freigabesignals (CHIPREADY) bewirkt, folgende zeitlich aufeinanderfolgende Kommandosequenzen umfasst:
a) erstens PRE, zweitens ARF, drittens MRS, oder
b) erstens PRE, zweitens MRS, drittens ARF, oder
c) erstens MRS, zweitens PRE, oder drittens ARF,
wobei die Abkürzungen folgende Kommandos bezeichnen:
PRE = Vorbereitungskommando für die Wortleitungsaktivierung (PRECHARGE),
ARF = Auffrischungskommando (AUTOREFRESH), und
MRS = Lade-Konfigurations-Register-Kommando (MODE-REGISTER-SET).

10. Verfahren zur Initialisierung einer dynamischen Halbleiter-Speichervorrichtung vom wahlweisen Zugriffstyp (DRAM/SDRAM) vermittels einer den Einschaltvorgang der Halbleiter-Speichervorrichtung und ihrer Schaltungsbestandteile steuernden Initialisierungsschaltung, welche nach einer nach dem Einschalten der Halbleiter-Speichervorrichtung erfolgten Stabilisierung der Versorgungsspannung ein Versorgungsspannungsstabilsignal (POWERON) liefert,
wobei die Initialisierungsschaltung vermittels einer dem Versorgungsspannungsstabilsignal (POWERON) und weiteren, von außen an die Halbleiter-Speichervorrichtung angelegten Kommandosignalen (PRE, ARF, MRS) zugeordneten Freigabeschaltung (9) nach dem Erkennen einer vorbestimmten ordnungsgemäßen Initialisierungsabfolge der an die Halbleiter-Speichervorrichtung angelegten Kommandosignale ein Freigabesignal (CHIPREADY) liefert, welches die Entriegelung der zum ordnungsgemäßen Betrieb der Halbleiter-Speichervorrichtung vorgesehenen Steuerschaltung (13) bewirkt,
**dadurch gekennzeichnet,**
**dass** die von außen an die Halbleiter-Speichervorrichtung angelegten Kommandosignale (PRE, ARF, MRS)der von der Freigabeschaltung (9) erkennenden Initialisierungsabfolge das Vorbereitungskommando für die Wortleitungsaktivierung (PRECHARGE), und/oder das Auffrischungskommando (AUTOREFRESH), und/oder das Lade-Konfigurations-Register-Kommando (MODE-REGISTER-SET) aufweist.

11. Verfahren nach Anspruch 10,
**dadurch gekennzeichnet,**
**dass** die Ausgangstreiber der:Halbleiter-Speichervorrichtung beim Einschaltvorgang bis zur Ausgabe des von der Freigabeschaltung (9) gelieferten Freigabesignals (CHIPREADY) verriegelt bleiben.

## Claims

1. Dynamic semiconductor memory device of the random access type (DRAM/SDRAM) having an initialization circuit which controls the switch-on operation of the semiconductor memory device and of its circuit components and supplies a supply voltage stable signal (POWERON) once the supply voltage has been stabilized after the switch-on of the semiconductor memory device, the initialization circuit having an enable circuit (9), which is assigned to the supply voltage stable signal (POWERON) and to further command signals (PRE, ARF, MRS) externally applied to the semiconductor memory device and supplies an enable signal (CHIPREADY) after the identification of a predetermined proper initialization sequence of the command signals (PRE, ARF, MRS) applied to the semiconductor memory device, which enable signal effects the unlatching of a control circuit (13) provided for the proper operation of the semiconductor memory device,
**characterized in that** the command signals (PRE, ARF, MRS) - externally applied to the semiconductor memory device - of the initialization sequence to be identified by the enable circuit (9) have the preparation command for word line activation (PRECHARGE), and/or the refresh command (AUTOREFRESH), and/or the loading configuration register command (MODE-REGISTER-SET).

2. Semiconductor memory device according to Claim 1, **characterized in that** the enable circuit (9) has at least one bistable multivibrator stage (14, 15, 16) with a set input (S), to which a command signal (PRECHARGE, AUTOREFRESH, MODE-REGISTER-SET) is applied, a reset input (R), to which the supply voltage stable signal (POWERON) or a signal derived therefrom or a linked signal is applied, and with an output (Q), at which the enable signal (CHIPREADY) (9) is derived.

3. Semiconductor memory device according to Claim 2, **characterized in that** the enable circuit (9) has a plurality of bistable multivibrator stages (14, 15, 16) respectively assigned to a command signal (PRE, ARF, MRS).

4. Semiconductor memory device according to Claim 2 or 3,
**characterized in that** the output (Q) of at least one of the bistable multivibrator stages (14) is passed to a reset input of a further multivibrator stage (15).

5. Semiconductor memory device according to Claims 3 or 4,
**characterized in that**, in one of the bistable multivibrator stages (15), the supply voltage stable signal (POWERON) and the signal output from the output (Q) of a further multivibrator stage (14) are passed, after having been logically combined by means of a gate (17), to the reset input (R) of the multivibrator stage (15).

6. Semiconductor memory device according to one of Claims 3 to 5,
**characterized in that** the bistable multivibrator stage (14, 15, 16) is in each case formed by an RS flip-flop constructed from at least two NOR or NAND gates (14A, 14B, 15A, 17, 16A, 16B).

7. Semiconductor memory device according to one of Claims 1 to 6,
**characterized in that** the initialization sequence which is identified as a proper initialization sequence by the enable circuit (9) and triggers the enable signal (CHIPREADY) constitutes a command sequence conforming to the JEDEC standard.

8. Semiconductor memory device according to one of Claims 1 to 7,
**characterized in that** the output drivers of the semiconductor memory device remain latched during the switch-on operation until the outputting of the enable signal (CHIPREADY) supplied by the enable circuit (9).

9. Semiconductor memory device according to one of Claims 1 to 8,
**characterized in that** a proper initialization sequence which effects the triggering of an enable signal (CHIPREADY) comprises the following chronologically successive command sequences:
a) firstly PRE, secondly ARF, thirdly MRS, or
b) firstly PRE, secondly MRS, thirdly ARF, or
c) firstly MRS, secondly PRE, or thirdly ARF,
where the abbreviations designate the following commands:
PRE = preparation command for word line activation (PRECHARGE)
ARF = refresh command (AUTOREFRESH), and
MRS = loading configuration register command (MODE-REGISTER-SET) .

10. Method for initializing a dynamic semiconductor memory device of the random access type (DRAM/SDRAM) by means of an initialization circuit which controls the switch-on operation of the semiconductor memory device and of its circuit components and supplies a supply voltage stable signal (POWERON) once the supply voltage has been stabilized after the switch-on of the semiconductor memory device, the initialization circuit supplying an enable signal (CHIPREADY) by means of an enable circuit (9), which is assigned to the supply voltage stable signal (POWERON) and to further command signals (PRE, ARF, MRS) externally applied to the semiconductor memory device, after the identification of a predetermined proper initialization sequence of the command signals applied to the semiconductor memory device, which enable signal effects the unlatching of the control circuit (13) provided for the proper operation of the semiconductor memory device,
**characterized in that** the command signals (PRE, ARF, MRS) - externally applied to the semiconductor memory device - of the initialization sequence to be identified by the enable circuit (9) have the preparation command for word line activation (PRECHARGE), and/or the refresh command (AUTOREFRESH), and/or the loading configuration register command (MODE-REGISTER-SET).

11. Method according to Claim 10,
**characterized in that** the output drivers of the semiconductor memory device remain latched during the switch-on operation until the outputting of the enable signal (CHIPREADY) supplied by the enable circuit (9)

## Revendications

1. Dispositif de mémorisation dynamique à semi-conducteur du type à accès optionnel (DRAM/SDRAM), comportant un circuit d'initialisation qui commande le processus de connexion du dispositif de mémorisation à semi-conducteur et de ses parties constitutives de circuit et qui fournit un signal stable de tension d'alimentation (POWERON) une fois que la tension d'alimentation est stabilisée après la connexion du dispositif de mémorisation à semi-conducteur,
le circuit d'initialisation comportant un circuit de libération (9), qui est associé au signal stable de tension d'alimentation (POWERON) et à d'autres signaux de commande (PRE, ARF, MRS) appliqués de l'extérieur au dispositif de mémorisation à semi-conducteur et qui fournit, après détection d'une suite d'initialisation ordonnée prédéterminée des signaux de commande (PRE, ARF, MRS) appliqués au dispositif de mémorisation à semi-conducteur, un signal de libération (CHIPREADY), qui provoque le déverrouillage d'un circuit de commande (13) prévu pour faire fonctionner correctement le dispositif de mémorisation à semi-conducteur,
**caractérisé en ce que** les signaux de commande (PRE, ARF, MRS), appliqués de l'extérieur au dispositif de mémorisation à semi-conducteur, de la suite d'initialisation détectée par le circuit de libération (9) comportent la commande de préparation de l'activation de la ligne de mot (PRECHARGE), et/ou la commande de rafraîchissement (AUTOREFRESH) et/ou la commande de registre de configuration de charge (MODE-REGISTER-SET).

2. Dispositif de mémorisation à semi-conducteur selon la revendication 1, **caractérise en ce que** le circuit de libération (9) comporte au moins un étage de bascule bistable (14, 15, 16), qui comporte une entrée de positionnement (S), à laquelle est appliquée un signal de commande (PRECHARGE, AUTOREFRESH, MODE-REGISTER-SET), une entrée de réinitialisation (R), à laquelle est appliqué le signal stable de tension d'alimentation (POWERON) ou un signal combiné ou dérivé de celui-ci, et une sortie (Q) sur laquelle est prélevé le signal de libération (CHIPREADY) (9).

3. Dispositif de mémorisation à semi-conducteur selon la revendication 2, **caractérisé en ce que** le circuit de libération (9) comporte plusieurs étages de bascules bistable (14, 15, 16) associés chacun à un signal de commande (PRE, ARF, MRS).

4. Dispositif de mémorisation à semi-conducteur selon la revendication 2 ou 3, **caractérisé en ce que** la sortie (Q) de l'au moins un des étages de bascule bistable (14) est amenée à une entrée de repositionnement d'un autre étage de bascule bistable (15).

5. Dispositif de mémorisation à semi-conducteur selon la revendication 3 ou 4, **caractérisé en ce que**, dans l'un des étages de bascule bistable (15), le signal stable de tension d'alimentation (POWERON) et le signal délivré par la sortie (Q) d'un autre étage de bascule bistable (14) sont amenés à l'entrée de repositionnement (R) de l'étage de bascule bistable (15) en étant combiné logiquement par une porte (17).

6. Dispositif de mémorisation à semi-conducteur selon l'une des revendications 3 à 5, **caractérisé en ce que** les étages de bascule bistable (14, 15, 16) sont conformés chacun en bascule RS Flip-Flop comportant au moins deux portes NOR ou NAND (14A, 14B, 15A, 17, 16A, 16B).

7. Dispositif de mémorisation à semi-conducteur selon l'une des revendications 1 à 6, **caractérisé en ce que** la suite d'initialisation, détectée par le circuit de libération (9) sous la forme d'une suite d'initialisation ordonnée et déclenchant le signal de libération (CHIPREADY), représente une séquence de commandes conforme à la norme JEDEC.

8. Dispositif de mémorisation à semi-conducteur selon l'une des revendications 1 à 7, **caractérisé en ce que** l'étage d'attaque en sortie du dispositif de mémorisation à semi-conducteur reste verrouillé lors du processus de connexion jusqu'à la sortie du signal de libération (CHIPREADY) délivré par le circuit de libération (9).

9. Dispositif de mémorisation à semi-conducteur selon l'une des revendications 1 à 1 8, **caractérisé en ce qu'**une suite d'initialisations ordonnée, qui commande le déclenchement d'un signal de libération (CHIPREADY), comporte les séquences de commande successives suivantes :
a) en premier PRE, en deuxième ARF, en troisième MRS, ou
b) en premier PRE, en deuxième MRS, en troisième ARF, ou
c) en premier MRS, en deuxième PRE, en troisième ARF,
les abréviations désignant les commandes suivantes :
PRE = commande de préparation de l'activation de ligne de mot (PRECHARGE),
ARF = commande de rafraîchissement (AUTOREFRESH), et
MRS = commande de registre de configuration de charge (MODE-REGISTER-SET).

10. Procédé d'initialisation d'un dispositif de mémorisation dynamique à semi-conducteur du type à accès optionnel (DRAM/SDRAM) au moyen d'un circuit d'initialisation qui commande le processus de connexion du dispositif de mémorisation à semi-conducteur et de ses parties constitutives de circuit et qui fournit un signal stable de tension d'alimentation (POWERON) une fois que la tension d'alimentation est stabilisée après la connexion du dispositif de mémorisation à semi-conducteur,
le circuit d'initialisation fournissant au moyen d'un circuit de libération (9), qui est associé au signal stable de tension d'alimentation (POWERON) et à d'autres signaux de commande (PRE, ARF, MRS) appliqués de l'extérieur au dispositif de mémorisation à semi-conducteur, après détection d'une suite d'initialisation ordonnée prédéterminée des signaux de commande (PRE, ARF, MRS) appliqués au dispositif de mémorisation à semi-conducteur, un signal de libération (CHIPREADY) qui provoque le déverrouillage d'un circuit de commande (13) prévu pour faire fonctionner correctement le dispositif de mémorisation à semi-conducteur,
**caractérisé en ce que** les signaux de commande (PRE, ARF, MRS), appliqués de l'extérieur au dispositif de mémorisation à semi-conducteur, de la suite d'initialisation détectée par le circuit de libération (9) comportent la commande de préparation de l'activation de la ligne de mot (PRECHARGE), et/ou la commande de rafraîchissement (AUTOREFRESH) et/ou la commande de registre de configuration de charge (MODE-REGISTER-SET).

11. Procédé selon la revendication 10, **caractérisé en ce que** l'étage d'attaque en sortie du dispositif de mémorisation à semi-conducteur reste verrouillé lors du processus de connexion jusqu'à la sortie du signal de libération (CHIPREADY) fourni par le circuit de libération (9).
